# EUROPEAN PATENT SPECIFICATION

(11) **EP 1 660 892 B1**
(45) Date of publication and mention of the grant of the patent: **02.10.2013**
(21) Application number: 04738012.6
(22) Date of filing: 28.07.2004
(51) Int. Cl.: G01R 21/00, G01R 23/00

(54) **DUAL SIGNAL RF POWER LEVEL DETECTOR**
DOPPELSIGNAL-HF-LEISTUNGSPEGELDETEKTOR
DETECTEUR DOUBLE DE NIVEAU DE PUISSANCE DE SIGNAL RF

(30) Priority: 28.07.2003 US 490269 P
(43) Date of publication of application: 31.05.2006
(73) Proprietor: SIGE Semiconductor Inc, Ottawa, Ontario K2H 8K7 (CA)
(72) Inventor: YUEN, Gregory, Weng, Mun, Essex CM17 9PX (GB); WHITTAKER, Edward, John, Wemyss, Hertfordshire CM23 4EY (GB)
(74) Representative: Lloyd, Patrick Alexander Desmond
(86) International application number: PCT/CA2004/001404
(87) International publication number: WO 2005/012927

(56) References cited:
- WO-A1-02/082638
- US-A- 6 002 922
- US-B1- 6 571 087
- MEYER ET AL.: 'Low-power monolithic RF peak detector analysis' IEEE JOURNAL OF SOLID-STATE CIRCUIT vol. 30, no. 1, January 1995, pages 65 - 67
- POLLANEN O.: 'Integrated power measurement circuits for RF power amplifiers' RADIO AND WIRELESS CONFERENCE 10 September 2000 - 13 September 2000, pages 235 - 238, XP010521075

## Description

### Field of the Invention

The invention relates to the field of power level detectors and more specifically to the field of RF signal power detection.

### Background of the Invention

In a radio frequency (RF) power amplifier integrated circuit (PAIC), an input RF signal is provided to the PAIC for amplification to provide an amplified RF signal. This amplified RF signal is typically propagated along a RF transmitter path to an antenna. In many cases, output power of the amplified RF signal is used within a feedback circuit in order to control the PAIC. Thus, output power of the amplified RF signal is often detected using a detector circuit disposed with the PAIC itself or with the use of an external coupler circuit disposed further downstream in the RF transmitter path and in proximity of the antenna. The use of either the internal detection circuitry or external detector circuitry gives an end user a choice between high accuracy in determining the RF output signal power with the commensurate increase in the bill of materials (BOM), or moderate accuracy using the internal detector to sense the output signal level, with no increase in BOM costs.

Some end users require a high level of accuracy in detection of the RF output signal power in order to comply with emission specification and the 802.11 standards. Others end users are less concerned about the accuracy and are interested in minimizing costs of the final assembly.

It is well known to those of skill in the art that an accurate way to measure the output signal RF level delivered to the antenna coupled to the PAIC of a transmitter is to couple a portion of the signal using a coupler circuit in conjunction with a RF signal level detector. With the use of a coupler circuit, a mismatch between the PA and feedline to the antenna is inherently accounted for because the coupler circuit couples a consistent portion of the RF signal regardless of the mismatch. In contrast, measuring the RF output signal level within the PAIC introduces measurement error since any mismatch between the PAIC and the feedline or antenna is not taken into account. This mismatch between the PA and feedline to the antenna is inherently accounted for because the coupler circuit couples a consistent portion of the RF signal regardless of the mismatch. In contrast, measuring the RF output signal level within the PAIC introduces measurement error since any mismatch between the PAIC and the feedline or antenna is not taken into account. This mismatch, of course, reduces the amount of RF signal actually accepted by the feedline or antenna.

Generally, for measuring the external RF signal power level, discrete component solutions are offered, which are wasteful in terms of cost and board area. For example, one might consider using an external RF coupler with a board-level detector for delivering a signal level back to the PAIC or other control circuit. In this case, the PAIC is used as a RF amplifier and the actual RF output signal introduced to the feedline or antenna is measured with a relatively high degree of accuracy. Unfortunately, the coupler and external detector have additional cost and consume board area.

Alternatively, only the internal detector circuitry disposed within the PAIC is used to measure the RF output signal level provided by the PAIC. This approach minimizes costs because detector circuitry is internal, however the accuracy is diminished because the internal detector circuitry does not take into account mismatch and other losses in the feedline.

A need therefore exists to provide a detector circuit that facilitates measuring of the RF output signal level both internally and through the use of an external RF coupler. We have therefore appreciated that it would be desirable to provide a detector circuit that overcomes the limitations of the prior art.

US6002922 and US6571087 discloses known apparatus for detecting the power levels of communication signals. Both devices have a high power mode and a low power detection mode.

### Summary of the Invention

The invention is defined in the independent claims to which reference should now be made. Advantageous features are set forth in the dependent claims.

In a first aspect, the invention provides a method of performing RF power detection within a power amplifier integrated circuit, the method comprising: providing an RF power level detector circuit, the RF power level detector circuit including an internal signal port internal to the power amplifier integrated circuit for receiving a first RF signal from inside the power amplifier integrated circuit the first RF signal being an amplified RF signal to be supplied to an output port of the power amplifier integrated circuit, and an external signal port external to the power amplifier integrated circuit for receiving a second RF signal, the second RF signal being an amplified RF signal output from the output port of the power amplifier integrated circuit, an RF power level detector, and a signal detector for detecting the presence of the second RF signal at the external signal port and for providing a control signal in dependence upon the detected presence of the second RF signal; and switchably selecting, dependent on the control signal, between providing an output power signal dependent on the first RF signal when the control signal is other than indicative of a presence of the second RF signal at the external signal port, and providing an output power signal dependent on the second RF signal when the control signal is indicative of a presence of the second RF signal on the external signal port.

In a second aspect, the invention provides a RF power level detector circuit for detecting performing RF power detection within a power amplifier integrated circuit, comprising: an internal signal port for coupling internally to the power amplifier integrated circuit (200) for receiving a first RF signal from inside the power amplifier integrated circuit (200), the first RF signal being an amplified RF signal to be supplied to an output port of the power amplifier integrated circuit, and an external signal port for coupling externally to the power amplifier integrated circuit for receiving a second RF signal, the second RF signal being an amplified RF signal output from the output port of the power amplifier integrated circuit, a power level detector, and a signal detector for detecting the presence of the second RF signal at the external signal port and for providing a control signal in dependence upon the detected presence of the second RF signal; and a switch for selecting, dependent on the control signal, between providing an output power signal dependent on the first RF signal, when the control signal is other than indicative of a presence of the second RF signal at the external signal port, and providing an output power signal dependent on the second RF signal when the control signal is indicative of a presence of the second RF signal on the external signal port.

### Brief Description of the Drawings

Exemplary embodiments of the invention will now be described in conjunction with the following drawings, in which:

FIG. 1a illustrates a dual signal RF power level detector circuit in accordance with a first embodiment of the invention;

FIG. 1b illustrates a second embodiment of the invention, which is a variation of the first embodiment shown in FIG. 1a;

FIG. 2a illustrates the dual signal RF power level detector circuit, in accordance with the first embodiment of the invention, when used in conjunction with a power amplifier integrated circuit (PAIC);

FIG. 2b illustrates the dual signal RF power level detector circuit when used in conjunction with a power amplifier integrated circuit (PAIC) and an external coupler circuit;

FIG. 3a illustrates an internal coupled detector response for the slope selection signal being indicative of a positive slope where the signal indicative of the propagating RF energy has a positive rate of change with respect to the RF output signal power;

FIG. 3b illustrates the internal coupled detector response being indicative of negative slope where the signal indicative of the propagating RF energy has a negative rate of change with respect to the RF output signal power;

FIG. 4a illustrates an external coupled detector response for the slope selection signal being indicative of a positive slope where the signal indicative of the propagating RF energy has a positive rate of change with respect to the input signal power received from the coupler circuit;

FIG. 4b illustrates the external coupled detector response being indicative of negative slope where the signal indicative of the propagating RF energy has a negative rate of change with respect to the input signal power received from the coupler circuit;

FIG. 5 is a schematic diagram of a power level detector circuit for providing a negative slope output response vs. Input signal power level; and,

FIG. 6 is a schematic diagram of a power level detection circuit for providing in a switchable manner both positive and negative slope output response vs. Input signal power level.

### Detailed Description the Invention

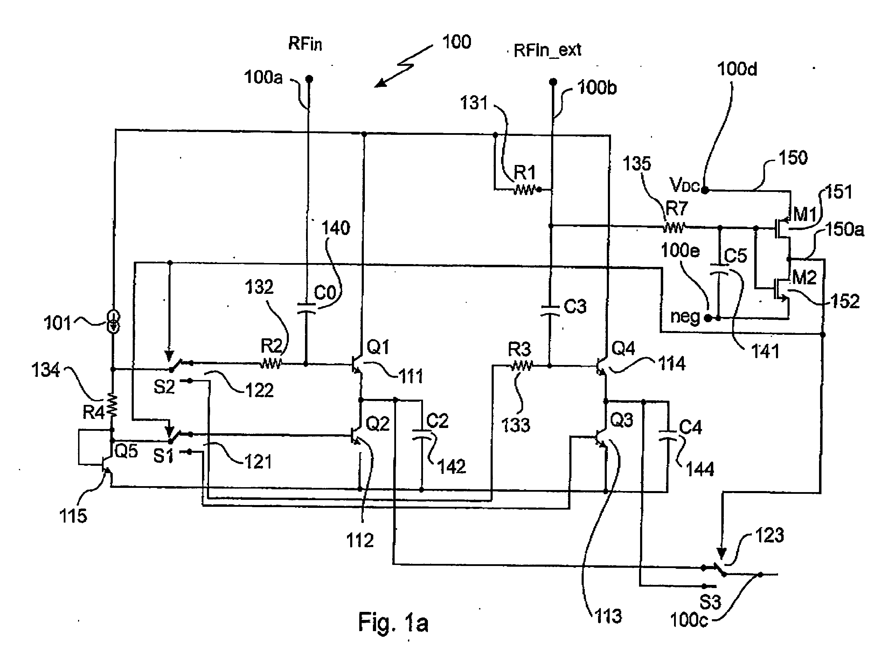

FIG. 1a illustrates a dual signal RF power level detector circuit 100 in accordance with a first embodiment of the invention. A first portion of a power level detector circuit is formed using a first transistor Q1 111 and a second portion of a power level detector circuit is formed using a fourth transistor Q4 114. Thus, transistors Q1 111 and Q4 114 serve as two detection transistors. The two detection transistors are powered by switchably selecting current provided to their base terminals by switchably selecting current to flow from their respective current source transistors Q2 112 and Q3 113. A first switching circuit 121, a second switching circuit 122 and a third switching circuit 123 control current provided to the detection transistors and the current source transistors. The switching circuits, 121, 122 and 123 are controlled by a decision logic circuit 150 having a switch control port 150a for providing a switch control signal therefrom. The switch control signal is received by each of the switches for controlling of their switched state. The first switching circuit 121 is provided with a first switched terminal directly connected to the base terminal of Q2 112, a second switched terminal directly connected to the base terminal of Q3 113 and a first control terminal coupled to the switch control port 101c. The second switching circuit 122 is provided with a first switched terminal resistively connected, using series resistor R2 132, to the base terminal of Q1 111. A second switched terminal of the second switching circuit 122 has a second switched terminal directly connected to the base terminal of Q2 112 and a second control terminal coupled to the switch control port 101c. The third switching circuit 123 has a first switched terminal directly connected to the emitter terminal of Q1 111, a second switched terminal directly connected to the emitter terminal of Q4 114 and a third control terminal coupled to the switch control port 100c. A common terminal of the third switching circuit 123 acts as an output port 100c for providing a signal indicative of the detected RF signal power from either the first detector circuit, comprising Q1 111 and Q2 112, or the second detector circuit, comprising Q3 113 and Q4 114, in dependence upon a state of this switch as selected by the decision logic 150. A coupling capacitor C0 140 is disposed between the first signal input port 100a and the base terminal of Q1 111 and another coupling capacitor is disposed between the second input port 100b and Q4 114. Capacitor C2 is disposed between the emitter terminal of Q1 111 and the emitter terminal of Q5 115. Capacitor C4 is disposed between the emitter terminal of Q2 112 and the emitter terminal of Q5 115.

Disposed within the decision logic circuit 150 are a first MOSFET 151 and a second MOSFET 152 having one of their drain and source terminals of each MOSFET connected together, with the other terminal of the first MOSFET 151 connected to a positive voltage supply terminal 100d and the other terminal of the second MOSFET 152 connected to a negative voltage supply terminal 100e. The gate terminals of the MOSFETs are directly connected together and coupled to a node of resistor R2 132 in series with the second input port 100b (RFin_ext). A filter capacitor 141 is disposed between the gate terminals of the MOSFETs and the negative voltage supply terminal 100e for filtering out RF signals from the logic signal provided from the decision logic circuit.

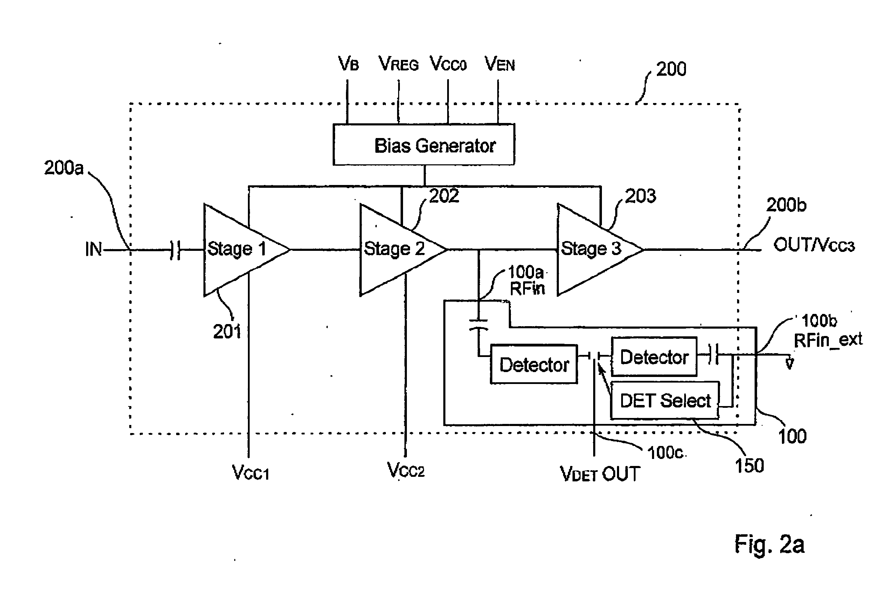

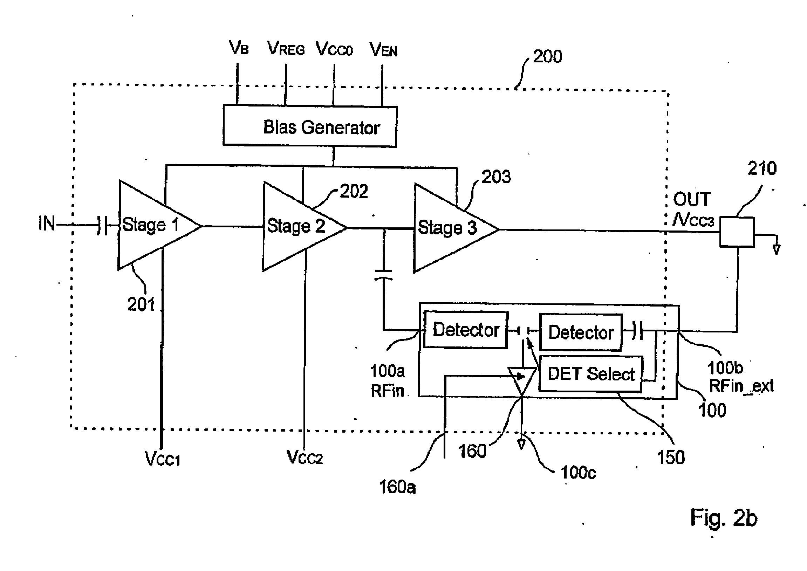

Two RF signal input ports are also disposed on the dual signal RF power level detector circuit 100. A first RF signal input port 100a, labeled RFin, is preferably directly connected to a RF amplifier circuit (FIG. 2a) for receiving of a RF signal. A second RF signal input port 100b, labeled RFin_ext, is preferably used in conjunction with an RF coupler (shown in FIG. 2b), which provides a more accurate method of measuring RF power in the presence of a mismatch condition along a feedline between an antenna and a power amplifier integrated circuit (PAIC) coupled thereto.

A current source 101, combined with resistor R4 134 in series with transistor Q5 115 is disposed to provide current to the base terminals of Q1 111 and Q4 114, and to their respective current source transistors Q2 112 and Q3 113. Individual detector circuitry from the two detector circuits is selected by routing all three switch connections as follows: a first switch connection to the series base resistor, either R2 132 or R3 133, of the respective detector transistor, either Q1 111 or Q2 112, a second switch connection to the current source transistor, either Q2 112 or Q3 113, of the respective detector transistor, either Q1 111 or Q2 112, and a third switch connection to the emitter terminal of the detector transistor, either Q1 111 or Q2 112.

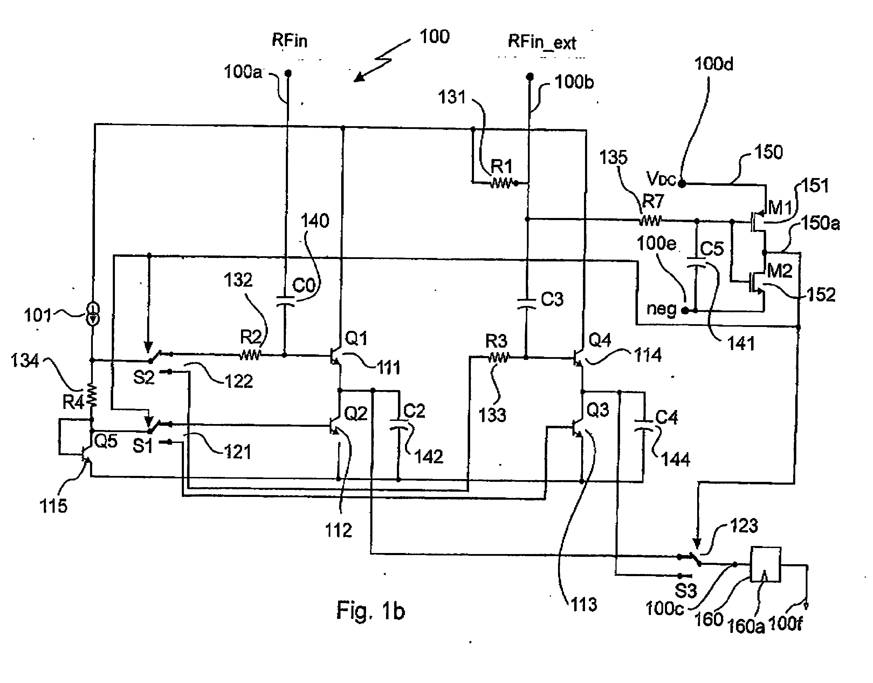

FIG. 1b illustrates a second embodiment of the invention 101, which is a variation of the first embodiment shown in FIG. 1a. Circuit components illustrated in FIG. 1b having the same numbering provide the same function as those listed for FIG. 1a. However, in the second embodiment, second RF signal input port 100b is preferably used in conjunction with an RF coupler (shown in FIG. 2b), which provides a more accurate method of measuring RF power in the presence of a mismatch condition along a feedline between an antenna and a power amplifier integrated circuit (PAIC) coupled thereto (FIG. 2b). In addition, an RF output signal level slope selection circuit 160 is coupled to the common terminal of the third switching circuit 123, output port 100c shown in FIG. 1a, for varying a slope of the signal indicative of the detected RF signal power from either the first detector circuit, comprising Q1 111 and Q2 112, or the second detector circuit, comprising Q3 113 and Q4 114, in dependence upon a slope selection signal provided to a slope circuit control port 160a. The signal representative of the propagating RF energy is provided from the output port 100c.

Switching between using of the first detector circuit, comprising Q1 111, for detecting of a RF signal level from a PAIC internal signal path (FIG. 2a) and the second detector circuit, comprising Q4, for detecting of a RF signal level from a PAIC external signal path (FIG. 2b) is accomplished by sensing a mean voltage on the second RF signal input port 100b (RFin_ext). When this second RF signal input port 101b is wired to an RF coupler circuit (210 FIG. 2b) via a capacitor C5 145 and the mean voltage at this port on the pin is "pulled up" by pullup resistor R1 131, then the decision circuit 150 senses the mean voltage on the second RF signal input port 101b through sense resistor 135 and provides a switch control signal from the switch control port 150a to all three switching circuits, 121, 122 and 123, for switchably selecting the second detection circuit and associated circuitry. If the second RF signal input port 100b is connected to ground, then the decision logic 150 provides a switch control signal that switchably selects the first detection circuit and associated circuitry. Thus, in dependence upon whether the dual signal RF power level detector circuit 100 is used with an external coupler circuit or not a signal indicative of the detected RF signal power is provided from the output port 100c.

FIG. 2a illustrates the dual signal RF power level detector circuit 100, in accordance with the first embodiment of the invention, when used in conjunction with a power amplifier integrated circuit (PAIC) 200. A RF input signal is provided to an input port 200a of the PAIC. The RF input signal propagates through a first amplification stage 201, a second amplification stage 202 and a third amplification stage 203. An output port 200b is coupled to the third amplification stage of the PAIC for providing an amplifier RF input signal therefrom. In this case, the dual signal RF power level detector circuit 100 is coupled using the first RF signal input port 100a to an output port of the third amplification stage 203 and no external coupler circuit is connected to the second RF signal input port 100b. In this case, the second RF signal input port 100b is preferably connected to ground. Output port 100c provides the signal indicative of the detected RF signal power from the first detector circuit, comprising Q1 111 and Q2 112.

FIG. 2b illustrates the dual signal RF power level detector circuit 100 when used in conjunction with a power amplifier integrated circuit (PAIC) 200 and an external coupler circuit 210. An RF input signal is provided to an input port 200a of the PAIC. The RF input signal propagates through a first amplification stage 201, a second amplification stage 202 and a third amplification stage 203. An output port 200b is coupled to the third amplification stage 203 of the PAIC for providing an amplifier RF input signal therefrom. The output port 200b is connected to an input port of a coupler circuit 210. The external coupler circuit 210 couples a portion of the RF signal into the second RF signal input port 100b (RFin_ext). Since a signal is present on this port, the decision circuitry 150 switchably changes the state of the three switches and the external coupler is used by the second detection circuitry for providing of the signal representative of the propagating RF energy from the output port 100c. A RF output signal level slope selection circuit 160 is coupled to output port 100c, which is connected to the common terminal of the third switching circuit 123. The function of the RF output signal level slope selection circuit 160 is for varying a slope of the signal indicative of the detected RF signal power from the second detector circuit, comprising Q3 113 and Q4 114, in dependence upon a slope selection signal provided to a slope circuit control port 160a.

A preferential scheme utilizing opposite polarity logic optionally allows for having the second RF signal input port 100b at the base terminal of Q4 114, thus removing coupling capacitor C5 141 from the circuit. However, if this coupling capacitor 141 is not used, then it results in the second RF signal input port 100b becoming biased at ground potential with a large RF signal superposed. Unfortunately, this results in triggering of ESD protection diodes (not shown) provided for the second RF signal input port 100b when this circuit is realised in conventional silicon technology. Of course, if ESD protection were not a requirement, then this limitation would not apply.

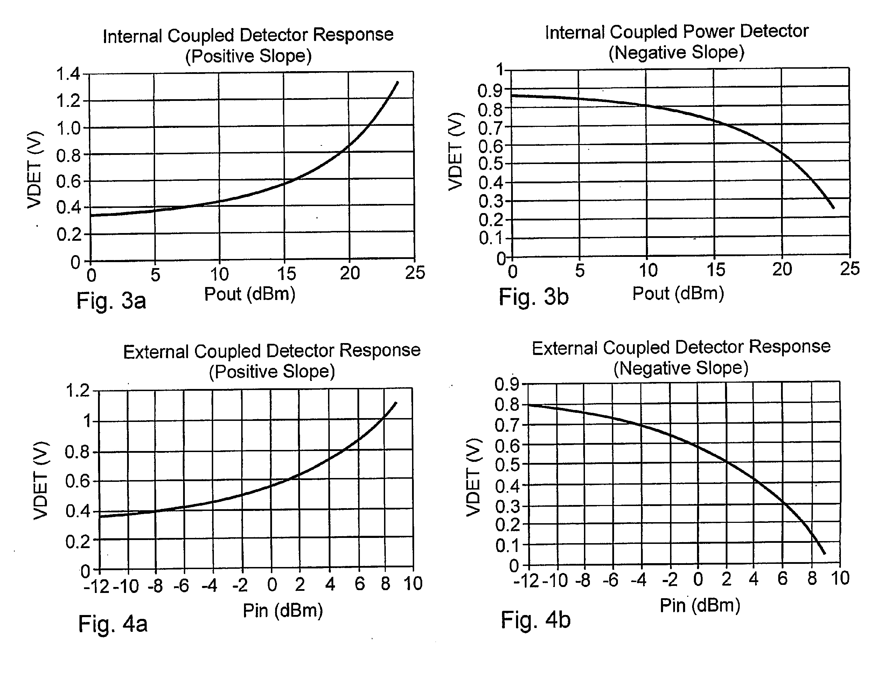

FIG. 3 a illustrates an internal coupled detector response for the slope selection signal being indicative of a positive slope where the signal indicative of the propagating RF energy has a positive rate of change with respect to the RF output signal power. FIG. 3b illustrates the internal coupled detector response being indicative of negative slope where the signal indicative of the propagating RF energy has a negative rate of change with respect to the RF output signal power. FIG. 4a illustrates an external coupled detector response for the slope selection signal being indicative of a positive slope where the signal indicative of the propagating RF energy has a positive rate of change with respect to the input signal power received from the coupler circuit 210. FIG. 4b illustrates the external coupled detector response being indicative of negative slope where the signal indicative of the propagating RF energy has a negative rate of change with respect to the input signal power received from the coupler circuit 210.

Each of the power level detector circuits is preferably based upon a detector circuit design found in the publication: "Low Power Monolithic RF Peak Detector Analysis" by Robert G. Meyer. IEEE JSSC Jan. 1995 pp.65-67, for its simplicity and low current consumption. This detector is best suited to detecting RF signal levels around 1 Volt, which are readily available at either the output or intermediate stages of a RF PAIC. Alternatively, a negative slope power level detector is used according to the prior art known negative slope power level detectors.

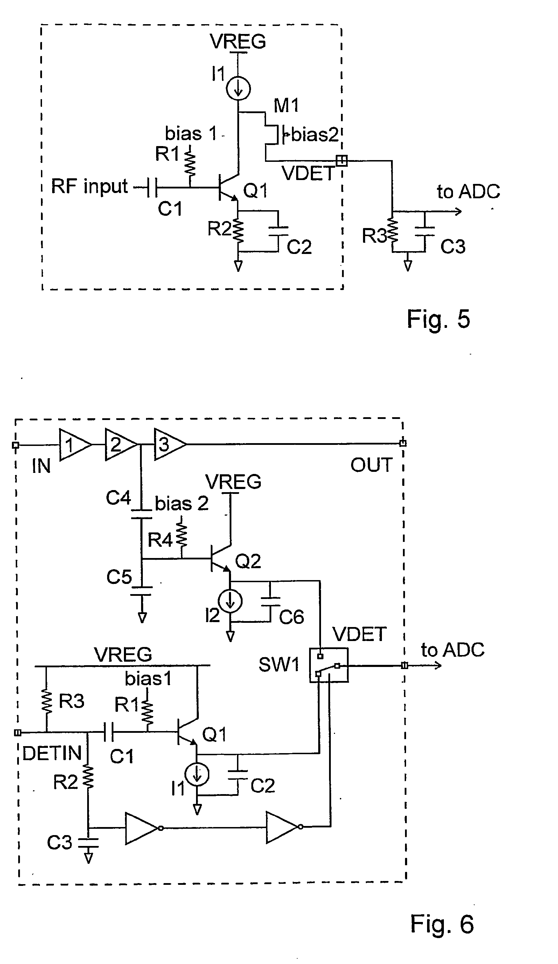

Referring to Fig. 5, a new power level detector circuit is shown. The power level detector circuit includes a PMOSFET M1 disposed with the NPN in a folded cascode arrangement. The current sink in the emitter load of the positive slope power level detector is replaced by a resistor R2. In this circuit, input voltage is converted to current by R2. This current subtracts from I1 so that the total current delivered to R3 is I1 minus a current proportional to the input voltage. The voltage across R3 decreases with an increasing signal. Operating characteristics are determined based on selection of R2, I1, and R3 including offset, slope, and any significant shunt resistance. C3 is optionally included for filtering when required. Thus, the circuit of Fig. 5 obviates a need for inverter logic - including an op-amp - such as that used in negative slope prior art circuits. Further, the circuit of Fig. 5 is relatively energy efficient following a similar model to that of the prior art positive slope integrated power level detector.

Referring to Fig. 6, a power level detector circuit is shown for switchably selecting between positive and negative slope output signals relative to input RF power level. A positive slope power level detector circuit as is known in the art is shown in parallel with a negative slope power level detector as shown in Fig. 5. The detector input pin is coupled to a switching circuit for switchably selecting between the parallel detector circuits. The resulting circuit provides for use of either positive or negative slope power level detectors. Further addition of switching logic permits use of an external power level detector or either of the internal power level detectors. This provides designers with maximum flexibility as well as, for many applications, reduced parts costs.

As above, by providing the input signal to the power level detector circuits via an external line, advantages are realised. The present embodiment can be implemented in accordance with the teachings set out above. In such an embodiment, two of the parallel power level detector circuits are disposed, one for receiving a signal from internal to the integrated circuit and the other for receiving a signal from external to the integrated circuit. The signal from external to the integrated circuit originates from within the integrated circuit. Switching between the two different power level detector circuits is performed automatically in dependence upon a presence or absence of an RF signal on the external RF signal input port. This obviates a need for a control pin (on the die) saving important resources for other design purposes.

Numerous other embodiments may be envisaged without departing from the scope of the following claims.

## Claims

1. A method of performing RF power detection within a power amplifier integrated circuit (200), the method comprising:
providing an RF power level detector circuit (100), the RF power level detector circuit (100) including an internal signal port (100a) internal to the power amplifier integrated circuit (200) for receiving a first RF signal from inside the power amplifier integrated circuit (200) the first RF signal being an amplified RF signal to be supplied to an output port of the power amplifier integrated circuit, and an external signal port (100b) external to the power amplifier integrated circuit for receiving a second RF signal, the second RF signal being an amplified RF signal output from the output port of the power amplifier integrated circuit (200), a power level detector (111,112,113,114), and a signal detector (150, 210) for detecting the presence of the second RF signal at the external signal port (100b) and for providing a control signal in dependence upon the detected presence of the second RF signal; and
switchably selecting, dependent on the control signal, between providing an output power signal of said power level detector dependent on the first RF signal when the control signal is other than indicative of a presence of the second RF signal at the external signal port (100b), and providing an output power signal of said power level detector dependent on the second RF signal when the control signal is indicative of a presence of the second RF signal on the external signal port (100b).

2. The method of claim 1 wherein the power level detector includes first (111, 112) and second (113, 114) power level detectors, the internal signal port (100a) is coupled to a first power level detector (111, 112), and the external signal port (100b) is coupled to a second power level detector (113, 114), the output signal from each of the first and second power level detectors is selectable for provision to the output port (100c) in dependence upon the control signal.

3. A method according to claim 2 wherein the RF power amplifier Integrated circuit (200) has a common output pin (VDET OUT) for outputting the output power signal, the common output pin (VDET OUT) being coupled to the output of the first and the second power level detectors, and the output signal from the selected one of the output signals from the first (111, 112) and second (113, 114) power level detectors being provided to the common output pin (VDET OUT).

4. A RF power level detector circuit (100) for detecting performing RF power detection within a power amplifier integrated circuit (200), comprising:
an internal signal port (100a) for coupling internally to the power amplifier integrated circuit (200) for receiving a first RF signal from inside the power amplifier integrated circuit (200), the first RF signal being an amplified RF signal to be supplied to an output port of the power amplifier integrated circuit, and an external signal port (100b) for coupling externally to the power amplifier integrated circuit for receiving a second RF signal, the second RF signal being an amplified RF signal output from the output port of the power amplifier integrated circuit (200), an power level detector (111,112,113,114), and a signal detector (150, 210) for detecting the presence of the second RF signal at the external signal port (100b) and for providing a control signal in dependence upon the detected presence of the second RF signal; and
a switch for selecting, dependent on the control signal, between providing an output power signal of said power level detector dependent on the first RF signal, when the control signal is other than indicative of a presence of the second RF signal at the external signal port (100b), and providing an output power signal of said power level detector dependent on the second RF signal when the control signal is indicative of a presence of the second RF signal on the external signal port (100b).

5. The RF power level detector circuit (100) of claim 4, wherein the power level detector includes first (111, 112) and second (113, 114) power level detectors, the internal signal port (100a) is coupled to the first power level detector (111, 112), and the external signal port (100b) is coupled to the second power level detector (113, 114), the output signal from each of the first (111, 112) and second power level detectors (113, 114) being selectable for provision to the output port (100c) in dependence upon the control signal.

6. The RF power level detector circuit (100) of claim 5 wherein the power amplifier integrated circuit (200) has a common output pin (VDET OUT) for outputting the output power signal, the common output pin (VDET OUT) being coupled to the output of the first and the second power level detectors, and the output signal from the selected one of the output signals from the first (111, 112) and second (113, 114) power level detectors being provided to the common output pin (VDET OUT).

7. The RF power level detector circuit (100) of claim 5 or 6 wherein the first power level detector (111, 112) is coupled to receive an RF signal propagating within the integrated circuit, the first power level detector disposed in parallel with the second power level detector (113, 114), the first power level detector providing a negative response slope In which the signal provided by the detector indicative of the propagating RF energy has a negative rate of change with respect to the RF signal power received from the internal signal port (100a), and the second power level detector providing a positive slope in which the signal indicative of the propagating RF energy has a positive rate of change with respect to the RF signal power received from the external signal port (100b).

8. The RF power level detector circuit (100) of claims 4 to 7 wherein the second power level detector (113, 114) includes the external signal port (100b) for receiving the second RF signal, a PMOSFET, and a NPN transistor arranged in a folded cascade arrangement, an emitter of the NPN transistor being coupled resistively to ground.

9. A power amplifier integrated circuit (200) comprising the RF power level detector circuit (100) of claims 4 to 8.

## Patentansprüche

1. Verfahren zum Durchführen von HF-Leistungsdetektion in einer integrierten Leistungsverstärkerschaltung (200), wobei das Verfahren Folgendes aufweist:
Bereitstellen einer HF-Leistungspegeldetektorschaltung (100), wobei die HF-Leistungspegeldetektorschaltung (100) Folgendes beinhaltet: einen in der integrierten Leistungsverstärkerschaltung (200) befindlichen internen Signalport (100a) zum Empfangen eines ersten HF-Signals aus dem Inneren der integrierten Leistungsverstärkerschaltung (200), wobei das erste HF-Signal ein verstärktes HF-Signal ist, das an einen Ausgangsport der integrierten Leistungsverstärkerschaltung anzulegen ist, und einen außerhalb der integrierten Leistungsverstärkerschaltung befindlichen externen Signalport (100b) zum Empfangen eines zweiten HF-Signals, wobei das zweite HF-Signal ein von dem Ausgangsport der integrierten Leistungsverstärkerschaltung (200) ausgegebenes verstärktes HF-Signal ist, einen Leistungspegeldetektor (111, 112, 113, 114) und einen Signaldetektor (150, 210) zum Erkennen der Anwesenheit des zweiten HF-Signals an dem externen Signalport (100b) und zum Bereitstellen eines Steuersignals in Abhängigkeit von der erkannten Anwesenheit des zweiten HF-Signals, und
je nach dem Steuersignal schaltbares Auswählen zwischen dem Bereitstellen eines Ausgangsleistungssignals des genannten Leistungspegeldetektors in Abhängigkeit von dem ersten HF-Signal, wenn das Steuersignal nicht eine Anwesenheit des zweiten HF-Signals an dem externen Signalport (100b) anzeigt, und Bereitstellen eines Ausgangsleistungssignals des genannten Leistungspegeldetektors in Abhängigkeit von dem zweiten HF-Signal, wenn das Steuersignal eine Anwesenheit des zweiten HF-Signals an dem externen Signalport (100b) anzeigt.

2. Verfahren nach Anspruch 1, wobei der Leistungspegeldetektor einen ersten (111, 112) und einen zweiten (113, 114) Leistungspegeldetektor beinhaltet, der interne Signalport (100a) mit einem ersten Leistungspegeldetektor (111, 112) gekoppelt ist und der externe Signalport (100b) mit einem zweiten Leistungspegeldetektor (113, 114) gekoppelt ist, wobei das Ausgangssignal von dem ersten und dem zweiten Leistungspegeldetektor jeweils in Abhängigkeit von dem Steuersignal zum Anlegen an den Ausgangsport (100c) auswählbar ist.

3. Verfahren nach Anspruch 2, wobei die integrierte HF-Leistungsverstärkerschaltung (200) einen gemeinsamen Ausgangspin (VDET OUT) zum Ausgeben des Ausgangsleistungssignals hat, der gemeinsame Ausgangspin (VDET OUT) mit dem Ausgang des ersten und des zweiten Leistungspegeldetektors gekoppelt ist und das Ausgangssignal aus dem ausgewählten der Ausgangssignale von dem ersten (111, 112) und dem zweiten (113, 114) Leistungspegeldetektor an den gemeinsamen Ausgangspin (VDET OUT) angelegt wird.

4. HF-Leistungspegeldetektorschaltung (100) zum Erkennen der Durchführung einer HF-Leistungsdetektion in einer integrierten Leistungsverstärkerschaltung (200), die Folgendes aufweist:
einen internen Signalport (100a) zum internen Koppeln mit der integrierten Leistungsverstärkerschaltung (200) zum Empfangen eines ersten HF-Signals aus dem Inneren der integrierten Leistungsverstärkerschaltung (200), wobei das erste HF-Signal ein verstärktes HF-Signal ist, das an einen Ausgangsport der integrierten Leistungsverstärkerschaltung anzulegen ist, und einen externen Signalport (100b) zum externen Koppeln mit der integrierten Leistungsverstärkerschaltung zum Empfangen eines zweiten HF-Signals, wobei das zweite HF-Signal ein von dem Ausgangsport der integrierten Leistungsverstärkerschaltung (200) ausgegebenes verstärktes HF-Signal ist, einen Leistungspegeldetektor (111, 112, 113, 114) und einen Signaldetektor (150, 210) zum Erkennen der Anwesenheit des zweiten HF-Signals an dem externen Signalport (100b) und zum Bereitstellen eines Steuersignals in Abhängigkeit von der erkannten Anwesenheit des zweiten HF-Signals und
einen Schalter zum Auswählen je nach dem Steuersignal zwischen dem Bereitstellen eines Ausgangsleistungssignals des genannten Leistungspegeldetektors in Abhängigkeit von dem ersten HF-Signal, wenn das Steuersignal nicht eine Anwesenheit des zweiten HF-Signals an dem externen Signalport (100b) anzeigt, und dem Bereitstellen eines Ausgangsleistungssignals des genannten Leistungspegeldetektors in Abhängigkeit von dem zweiten HF-Signal, wenn das Steuersignal eine Anwesenheit des zweiten HF-Signals an dem externen Signalport (100b) anzeigt.

5. HF-Leistungspegeldetektorschaltung (100) nach Anspruch 4, wobei der Leistungspegeldetektor erste (111, 112) und zweite (113, 114) Leistungspegeldetektoren beinhaltet, der interne Signalport (100a) mit dem ersten Leistungspegeldetektor (111, 112) gekoppelt ist und der externe Signalport (100b) mit dem zweiten Leistungspegeldetektor (113, 114) gekoppelt ist, wobei das Ausgangssignal von dem ersten (111, 112) und dem zweiten Leistungspegeldetektor (113, 114) jeweils in Abhängigkeit von dem Steuersignal zum Anlegen an den Ausgangsport (100c) auswählbar ist.

6. HF-Leistungspegeldetektorschaltung (100) nach Anspruch 5, wobei die integrierte Leistungsverstärkerschaltung (200) einen gemeinsamen Ausgangspin (VDET OUT) zum Ausgeben des Ausgangsleistungssignals hat, wobei der gemeinsame Ausgangspin (VDET OUT) mit dem Ausgang der ersten und der zweiten Leistungspegeldetektoren gekoppelt ist und das Ausgangssignal von dem ausgewählten der Ausgangssignale von dem ersten (111, 112) und dem zweiten (113, 114) Leistungspegeldetektor an den gemeinsamen Ausgangspin (VDET OUT) angelegt wird.

7. HF-Leistungspegeldetektorschaltung (100) nach Anspruch 5 oder 6, wobei der erste Leistungspegeldetektor (111, 112) zum Empfangen eines sich in der integrierten Schaltung fortpflanzenden HF-Signals gekoppelt ist, der erste Leistungspegeldetektor parallel zu dem zweiten Leistungspegeldetektor (113, 114) angeordnet ist, der erste Leistungspegeldetektor eine negative Frequenzgangflanke bereitstellt, wobei das von dem Detektor bereitgestellte Signal, das die sich fortpflanzende HF-Energie anzeigt, eine negative Änderungsrate in Bezug auf die von dem internen Signalport (100a) empfangene HF-Signalleistung hat, und der zweite Leistungspegeldetektor eine positive Flanke bereitstellt, wobei das Signal, das die sich fortpflanzende HF-Energie anzeigt, eine positive Änderungsrate in Bezug auf die von dem externen Signalport (100b) empfangene HF-Signalleistung hat.

8. HF-Leistungspegeldetektor (100) nach einem der Ansprüche 4 bis 7, wobei der zweite Leistungspegeldetektor (113, 114) den externen Signalport (100b) zum Empfangen des zweiten HF-Signals, einen PMOSFET und einen NPN-Transistor beinhaltet, die in einer gefalteten Kaskadenanordnung angeordnet sind, wobei ein Emitter des NPN-Transistors widerstandsbehaftet mit Erde gekoppelt ist.

9. Integrierte Leistungsverstärkerschaltung (200), die die HF-Leistungspegeldetektorschaltung (100) nach einem der Ansprüche 4 bis 8 aufweist.

## Revendications

1. Procédé d'exécution d'une détection de puissance RF dans un circuit intégré d'amplificateur de puissance (200), le procédé comprenant :
la fourniture d'un circuit de détecteur de niveau de puissance RF (100), le circuit de détecteur de niveau de puissance RF (100) comportant un port de signal interne (100a) interne au circuit intégré d'amplificateur de puissance (200) pour recevoir un premier signal RF depuis l'intérieur du circuit intégré d'amplificateur de puissance (200) le premier signal RF étant un signal RF amplifié destiné à être fourni à un port de sortie du circuit intégré d'amplificateur de puissance, et un port de signal externe (100b) externe au circuit intégré d'amplificateur de puissance pour recevoir un second signal RF, le second signal RF étant un signal RF amplifié sorti du port de sortie du circuit intégré d'amplificateur de puissance (200), un détecteur de niveau de puissance (111, 112, 113, 114), et un détecteur de signal (150, 210) pour détecter la présence du second signal RF au niveau du port de signal externe (100b) et pour fournir un signal de commande en fonction de la présence détectée du second signal RF ; et
la sélection permutable, en fonction du signal de commande, entre la fourniture d'un signal de puissance de sortie dudit détecteur de niveau de puissance en fonction du premier signal RF quand le signal de commande est autre qu'indicatif d'une présence du second signal RF au niveau du port de signal externe (100b), et la fourniture d'un signal de puissance de sortie dudit détecteur de niveau de puissance en fonction du second signal RF quand le signal de commande indique une présence du second signal RF sur le port de signal externe (100b).

2. Procédé selon la revendication 1, dans lequel le détecteur de niveau de puissance comporte des premier (111, 112) et second (113, 114) détecteurs de niveau de puissance, le port de signal interne (100a) est couplé à un premier détecteur de niveau de puissance (111, 112), et le port de signal externe (100b) est couplé à un second détecteur de niveau de puissance (113, 114), le signal de sortie de chacun des premier et second détecteurs de niveau de puissance étant sélectionnable pour être fourni au port de sortie (100c) en fonction du signal de commande.

3. Procédé selon la revendication 2, dans lequel le circuit intégré d'amplificateur de puissance RF (200) a une broche de sortie commune (VDET OUT) pour produire en sortie le signal de puissance de sortie, la broche de sortie commune (VDET OUT) étant couplée à la sortie des premier et second détecteurs de niveau de puissance, et le signal de sortie du signal sélectionné des signaux de sortie depuis les premier (111, 112) et second (113, 114) détecteurs de niveau de puissance étant fourni à la broche de sortie commune (VDET OUT).

4. Circuit de détecteur de niveau de puissance RF (100) pour détecter l'exécution d'une détection de puissance RF dans un circuit intégré d'amplificateur de puissance (200), comprenant :
un port de signal interne (100a) destiné à être couplé intérieurement au circuit intégré d'amplificateur de puissance (200) pour recevoir un premier signal RF depuis l'intérieur du circuit intégré d'amplificateur de puissance (200) le premier signal RF étant un signal RF amplifié destiné à être fourni à un port de sortie du circuit intégré d'amplificateur de puissance, et un port de signal externe (100b) destiné à être couplé extérieurement au circuit intégré d'amplificateur de puissance pour recevoir un second signal RF, le second signal RF étant un signal RF amplifié sorti du port de sortie du circuit intégré d'amplificateur de puissance (200), un détecteur de niveau de puissance (111, 112, 113, 114), et un détecteur de signal (150, 210) pour détecter la présence du second signal RF au niveau du port de signal externe (100b) et pour fournir un signal de commande en fonction de la présence détectée du second signal RF ; et
un commutateur pour sélectionner, en fonction du signal de commande, entre la fourniture d'un signal de puissance de sortie dudit détecteur de niveau de puissance en fonction du premier signal RF, quand le signal de commande est autre qu'indicatif d'une présence du second signal RF au niveau du port de signal externe (100b), et la fourniture d'un signal de puissance de sortie dudit détecteur de niveau de puissance en fonction du second signal RF quand le signal de commande indique une présence du second signal RF sur le port de signal externe (100b).

5. Circuit de détecteur de niveau de puissance RF (100) selon la revendication 4, dans lequel le détecteur de niveau de puissance comporte des premier (111, 112) et second (113, 114) détecteurs de niveau de puissance, le port de signal interne (100a) est couplé au premier détecteur de niveau de puissance (111, 112), et le port de signal externe (100b) est couplé au second détecteur de niveau de puissance (113, 114), le signal de sortie de chacun des premier (111, 112) et second (113, 114) détecteurs de niveau de puissance étant sélectionnable pour être fourni au port de sortie (100c) en fonction du signal de commande.

6. Circuit de détecteur de niveau de puissance RF (100) selon la revendication 5, dans lequel le circuit intégré d'amplificateur de puissance RF (200) a une broche de sortie commune (VDET OUT) pour produire en sortie le signal de puissance de sortie, la broche de sortie commune (VDET OUT) étant couplée à la sortie des premier et second détecteurs de niveau de puissance, et le signal de sortie du signal sélectionné des signaux de sortie depuis les premier (111, 112) et second (113, 114) détecteurs de niveau de puissance étant fourni à la broche de sortie commune (VDET OUT).

7. Circuit de détecteur de niveau de puissance RF (100) selon la revendication 5 ou 6, dans lequel le premier détecteur de niveau de puissance (111, 112) est couplé pour recevoir un signal RF se propageant dans le circuit intégré, le premier détecteur de niveau de puissance étant disposé parallèlement au second détecteur de niveau de puissance (113, 114), le premier détecteur de niveau de puissance fournissant une pente de réponse négative selon laquelle le signal fourni par le détecteur indicatif de l'énergie RF propagée a un taux de changement négatif par rapport à la puissance de signal RF reçue depuis le port de signal interne (100a), et le second détecteur de niveau de puissance fournissant une pente positive selon laquelle le signal indicatif de l'énergie RF propagée a un taux de changement positif par rapport à la puissance de signal RF reçue depuis le port de signal externe (100b).

8. Circuit de détecteur de niveau de puissance RF (100) selon les revendications 4 à 7, dans lequel le second détecteur de niveau de puissance (113, 114) comporte le port de signal externe (100b) pour recevoir le second signal RF, un PMOSFET, et un transistor NPN agencés en cascade repliée, un émetteur du transistor NPN étant couplé résistivement à la masse.

9. Circuit intégré d'amplificateur de puissance (200) comprenant le circuit de détecteur de niveau de puissance RF (100) selon les revendications 4 à 8.
